# EUROPEAN PATENT APPLICATION

(11) **EP 0 536 862 A1**
(43) Date of publication of application: **14.04.1993**
(21) Application number: 92250285.1
(22) Date of filing: 07.10.1992
(51) Int. Cl.: H01L 21/48

(54) **A method of forming a body with buried channels**

(30) Priority: 11.10.1991 US 775884
(71) Applicant: W.R. Grace & Co.-Conn., New York, New York 10036 (US)
(72) Inventor: Enloe, Jack Harrison, Columbia, MD 21045 (US); Lau, John Wing-Keung, Gaithersburg, MD 20878 (US)
(74) Representative: UEXKÜLL & STOLBERG

(57) **Abstract**

Dielectric ceramic bases (4), for electronic packaging, which contain buried channels are formed by joining two or more ceramic pieces (4a,4b) using hot pressing. A coating may be applied to one or more of the pieces to facilitate bonding. At least one of the piece surfaces to be joined has features (5) which result in a buried channel configuration on being joined with another ceramic piece. Preferably, the dielectric base is large and/or is formed from AlN.

## Description

### Background of the Invention

Integrated circuit devices (chips) typically require the use of "electronic packaging" to hold the devices while allowing electrical access to the devices.

Electronic packages often employ a dielectric ceramic base which acts as a stable, electrically insulating platform on which the various electronic devices can be mounted. The base is typically a solid monolith possibly containing metallization patterns. Conventional monolithic ceramic-type packages provide only limited design options due to their monolithic solid body nature.

Integrated circuit devices generate heat during operation due to ohmic heating. In designs involving relatively high electrical power, the amount of heat generated can be quite substantial. Since the performance of integrated circuit devices often deteriorates at elevated temperatures, dissipation of ohmic heat is essential to reliable electronic performance.

For low power designs, the ceramic base may provide adequate heat dissipation. Heat sinks may be incorporated into the package design to increase the cooling capacity. Heat sinks are typically metal and result in only a limited amount of increased cooling capacity. Some ceramics such as aluminum nitride may be used as the dielectric ceramic base to provide increased cooling capacity.

Some alumina base package designs have employed cooling channels within the alumina base. Cooling fluids such as liquid nitrogen are circulated through the channels to provide cooling for the electronics contained in the package. The cooling channels in these alumina base packages were made by a method similar to those methods used to make vias in the base. These alumina base packages are limited in ability to dissipate heat due to the moderate thermal conductivity of alumina.

At least one article has been published which speculates on AlN-based packages having cooling channels formed by the use of fugitive binder materials. No AlN packages with such channels have apparently been constructed, however, and it is not clear that the fugitive binder technique would be effective.

Accordingly, there is a need for improved methods for making package designs incorporating cooling channels. There is also a need for packages containing cooling channels in high thermal conductivity AlN base materials and for methods of making those packages.

### Summary of the Invention

The invention provides electronic package and dielectric ceramic base designs which possess superior cooling capability due to use of AlN ceramics containing cooling channels. The invention also provides methods of making those AlN packages or bases as well as other packages and dielectric bases which contain cooling channels. The invention also provides methods of making electronic packages or dielectric bases containing channels.

In one aspect, the invention provides a dielectric ceramic base comprising a high thermal conductivity dense aluminum nitride ceramic body containing at least one buried channel. The channel has at least one entrance at a surface of the body.

The invention also encompasses electronic packages comprising an AlN ceramic base containing at least one buried channel having an entrance at a surface of the package.

In preferred embodiments, the base may include multiple channels. The channels may be interconnected and/or may have common entrances or exits. The entrances or exits may be connected to manifolds or ducts for circulating fluid through the channels. The base contains a composite of ceramic materials.

The invention also encompasses a method of forming a ceramic body having buried channels, the method comprising:
a) forming at least two dense ceramic layers;
b) creating grooves in a surface of at least one of the layers;
c) contacting the grooved surface with a surface of another of the dense ceramic layers; and
d) heating the contacted layers under uniaxial pressure to bond the layers together.

A material adapted to facilitate bonding between the ceramic surfaces may be employed. The dense ceramic layers may be made from different materials if those materials have compatible physical properties (e.g. thermal expansion match, etc.). Variations of the process may include formation of a grooved ceramic using a replica technique as described in U.S. Patent 5,017,434 and in U.S. Patent Application serial no. 702,562, filed May 20, 1991. The disclosures of those cases are incorporated herein by reference.

### Brief Description of the Drawings

Figure 1 shows a grooved ceramic piece and a flat ceramic piece which may be joined to form a ceramic base with channels according to the invention.

Figure 2 shows a cross sectional view of the ceramic pieces of Figure 1.

Figure 3 shows the ceramic base resulting from joining the ceramic pieces shown in Figure 1.

Figure 4 shows an electronic package of the invention containing a plurality of channels.

Figure 5 shows the package of Figure 4 having a manifold connected over the channels.

Figure 6 shows an alternate configuration of channel openings on a ceramic base surface.

### Detailed Description of the Invention

The invention will be discussed regarding various aspects of the dielectric base and package design features. Then, methods of forming those substrates and packages will be discussed. It should be understood that the invention is not limited to the designs shown in the figures nor to the details of the example.

A principal design feature of the invention is presence of at least one physically accessible space (channel) in the interior of the ceramic base. Access to the channel is provided through one or more openings at one or more surfaces of the base. The number of accessible channels, their shape, and location within the base may be widely varied depending on the particular design.

The channel(s) is preferably elongated (i.e. having width(s) much smaller than the channel length(s)).
Preferably, the channel aspect ratio (length/width) is at least about 10, more preferably at least about 20. The base may contain any number of channels of whatever width desired. If there are a plurality of channels, the channels may optionally be interconnected in the interior of the base.

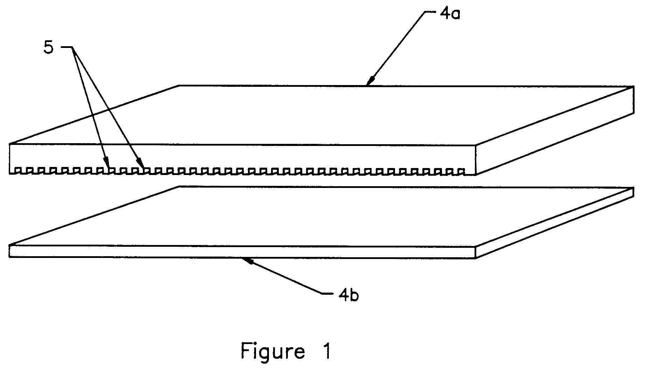

Figures 1-4 show an embodiment where a plurality of channels 2 run parallel from one side of base 4 to the other. The channels 2 need not be coplanar nor parallel as shown. The channels 2 may be designed with one or more openings at an exterior surface 18 of base 4. The openings for any particular channel may be located on different surfaces of the base or on the same surface. Some factors limiting the channel configuration are A) the available fabrication techniques, B) the intended function, and C) the mechanical integrity and strength of the ceramic.

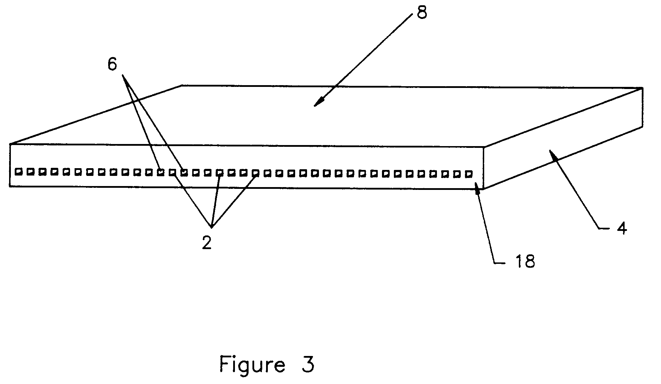

The channel walls 6 (Fig. 3) can be coated if desired. Portions of walls 6 may also be formed by metallization present in ceramic base 4. The base 4 may contain any desired internal and/or surface metallization configuration. If base 4 is part of an electronic package, at least some of the metallization is preferably configured to allow electronic communication with the integrated circuit chips located on surface 8 of base 4. Such a base 4 would also preferably contain surface metallization (e.g. lead pads 10 and seal ring 14) on its upper surface 8 and possibly on its lower surface (not shown). Any conventional configuration of chips (not shown) could be positioned on surface 8 at location 20 inside seal ring 14. If a hermetic package is desired, a cover (not shown) may be placed over the chips and attached to surface 8 at seal ring 14.

In order to circulate a cooling fluid through channels 2, a manifold 16 may be brazed to side 18 of base 4. The manifold 16 would then be connected to a source of coolant which could be circulated through the channels 2 by a pumping means (not shown). Different coolants may be used depending on the desired operating temperature. For cryogenic temperatures, liquid nitrogen or liquid helium may be used.

For dielectric bases comprising high thermal conductivity AlN, preferably at least the portion of the base between the chip attachment area 8 and channels 2 is formed of dense AlN. For higher thermal dissipation capability, the entire base 4 is preferably formed from AlN ceramic.

The methods of the invention may be used to make AlN bases having cooling channels, however the methods of the invention may also be used to make cooling channel bases from other suitable materials. The methods generally involve the formation of a least two separate densified ceramic pieces which are subsequently joined together. One of the ceramic pieces would have channels or grooves formed in the surface to be joined. The other piece may have grooves or holes in the surface or may be simply a flat monolithic plate.

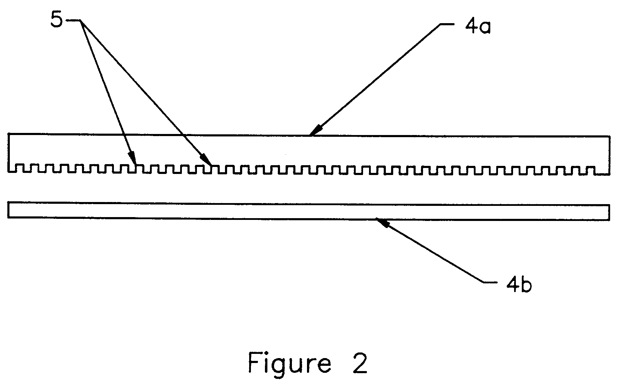

Figures 1 and 2 show an embodiment where one ceramic piece 4a has a grooved surface and the other piece 4b is simply a flat plate. The grooves 5 (or in some cases holes) may be formed by machining the densified ceramic piece or by use of any other known technique. One alternative method for forming these groove features is by use of the replica hot pressing technique described in U. S. Patent 5,017,434.

In the replica technique, the holes or grooves would be formed by inserting a non-sinterable material into the green ceramic piece where the holes or grooves are desired. A replica piece would then be laminated with the green ceramic piece for hot pressing in order to compensate for shrinkage differences between the green ceramic and non-sinterable material. The green ceramic would then be densified by hot pressing. After densification, the replica and the non-sinterable material would be removed to recover the densified ceramic piece with the desired grooves and/or holes.

The ceramic pieces to be joined together are then preferably laminated together and hot pressed under temperature and pressure conditions sufficient to cause bonding between the pieces. If the ceramic pieces are both made of the same ceramic material, these hot pressing conditions may be generally the same as or similar to those used for densification of the individual pieces. If desired, one or more of the surfaces to be joined can be coated with a bonding aid prior to lamination. For AlN ceramics, the aid is preferably a material containing CaCO₃, Y₂0₃, or other rare earth metal oxide. The bonding aid can be applied as a paint or in any other suitable form. The result of hot pressing pieces 4a and 4b is ceramic base 4 shown in Figure 3.

While the methods of the invention are suitable for making a dielectric ceramic base exclusively containing AlN as the ceramic material, the method may also be used to produce bases from other ceramic materials such as glasses, glass-ceramics, crystalline ceramics such as Al₂0₃ or ceramic composite mixtures. Also, the ceramic pieces to be joined need not be of the same composition if a) bonding can be achieved by hot pressing alone or with a bonding aid, and b) the compositions have compatible properties. A good match in thermal expansion properties between the compositions is especially important to avoid build up of excess residual stress on cooling.

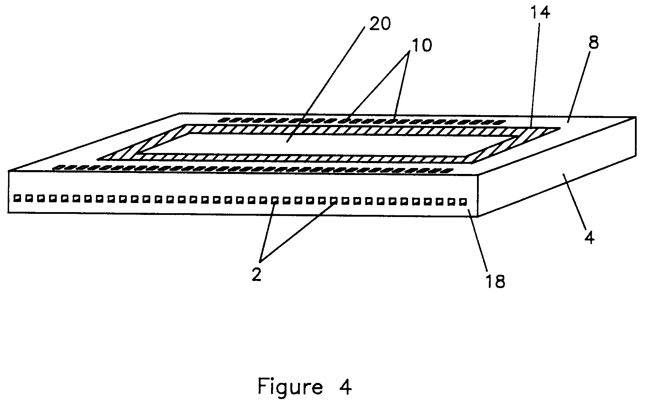

If the hot pressed ceramic base 4 of figure 3 is to be used as part of an electronic package, then it would typically have a metallization pattern on at least its top surface 8. An example of such a package is shown in figure 4.

Any suitable metallization may be configured in the ceramic base or on its surface(s). The metallization selected may vary depending on the base material and on the location of the location of the metallization (i.e. buried or surface). For example, buried metallization is typical co-fired with the ceramic base when the ceramic is densified. That metallization must be sufficiently refractory so that it does not flow or vaporize excessively during the densification firing.

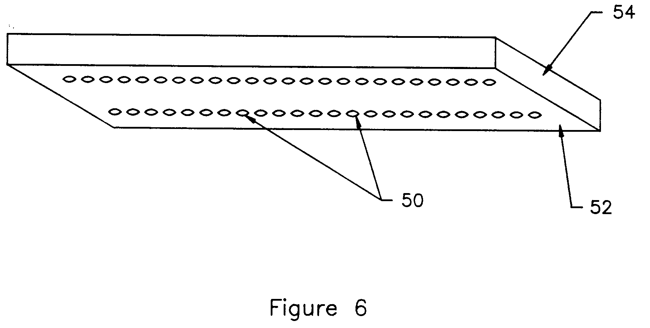

In an alternate configuration, the channels may be constructed with distinct inlet and outlet openings on the same surface. A preferred version of this configuration is illustrated in figure 6. Here the channel openings 50 are all located on lower surface 52 of base 54. The I.C. chips, to be housed in a package using base 54, would be located on the upper surface (not shown).

Openings 50 may be generated by machining a densified sheet. The openings may also be formed by the steps: a) punching holes in green ceramic sheets, b) filling the holes with a removable non-sinterable material, c) sintering the green sheets, and d) removing the non-sinterable material. Any other known method may alternately be employed.

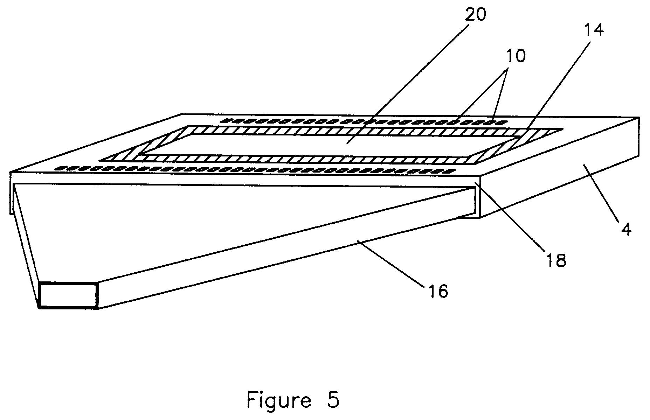

In order to circulate the cooling fluid through the channels, one or more manifolds 16 are preferably attached over the channel openings. The manifold(s) may be formed of any suitable material and may be attached by any known method suitable for the materials system involved. For metal manifolds, brazing is a preferred method of attachment. Figure 5 shows manifold 16 attached to base 4 at side 18.

### Example

A 5" square AlN plate having buried metallization was prepared in a manner described in U.S. Patent 4,920,640 and U.S. Patent Application Serial No. 631,577 filed Dec. 21, 1990, now the disclosures of which are incorporated herein by reference. 0.040" wide grooves where machined in a surface of metallized plate using a diamond saw.

A non-grooved AlN plate also prepared by hot pressing was coated with a thin layer of AlN/CaC0₃ paint (approx. 2 mils thick). The painted surface and the grooved surface were then bonded together by hot pressing at 500 psi and a maximum temperature of about 1800°C to yield the buried channel substrate of figure 3.

## Claims

1. A method of forming a ceramic body having buried channels, said method comprising:
a) forming at least two dense ceramic layers;
b) creating grooves in a surface of at least one of said layers;
c) contacting said grooved surface with a surface of another of said dense ceramic layers; and
d) heating said contacted layers under uniaxial pressure to bond said layers together thereby forming said body and channels.

2. The method of claim 1 wherein said grooved surface is contacted with a non-grooved surface in step c).

3. The method of claims 1 or 2 wherein at least one of said contacting surfaces is coated with a material adapted to facilitate the bonding of step d).

4. The method of claim 3 wherein said coating material comprises a ceramic powder.

5. The method of claim 4 wherein said ceramic layers comprise AlN and said ceramic powder contains a material selected from the group consisting of CaCO₃, Y₂O₃ and other rare earth oxides.

6. The method of claims 1 to 5 wherein said heating is done to a temperature of about 1800°C.

7. The method of claims 1 to 6 wherein said pressure is about 3450 kPa (500 psi).

8. The method of claims 1 to 7 wherein perforations are formed in one of said dense ceramic layers prior to step c).

9. The method of claim 8 wherein step c) comprises contacting said perforated layer with said grooved layer.

10. The method of claims 1 to 9, wherein at least one of said ceramic layers contains metallization.
